# EUROPÄISCHE PATENTSCHRIFT

(11) **EP 1 873 908 B1**
(45) Veröffentlichungstag und Bekanntmachung des Hinweises auf die Patenterteilung: **20.04.2011**
(21) Anmeldenummer: 07109316.5
(22) Anmeldetag: 31.05.2007
(51) Int. Cl.: H03F 1/52, H03F 3/191

(54) **Sende-Empfangsschaltung mit PIN-Dioden**
Transmit-receive circuit with PIN diodes
Circuit d'émission et de réception de diodes PIN

(30) Priorität: 26.06.2006 DE 102006029195
(43) Veröffentlichungstag der Anmeldung: 02.01.2008
(73) Patentinhaber: Siemens Audiologische Technik GmbH, 91058 Erlangen (DE)
(72) Erfinder: Boguslavskij, Mihail, 96450 Coburg (DE); Nikles, Peter, 91054 Erlangen (DE); Reithinger, Jürgen, 91077 Neunkirchen am Brand (DE); Schätzle, Ulrich, 91301 Forchheim (DE)
(74) Vertreter: Maier, Daniel Oliver

(56) Entgegenhaltungen:
- EP-A- 1 301 017
- WO-A-87/01199
- GB-A- 2 312 105
- US-A- 5 341 114

## Beschreibung

Die vorliegende Erfindung betrifft eine Sende-Empfangsschaltung mit einer Sende-Empfangsantenne zum induktiven Übertragen von Signalen, einem Empfangsschwingkreis, der an die Sende-Empfangsantenne angeschlossen ist, und einem Verstärker, der an den Empfangsschwingkreis angeschlossen ist. Insbesondere betrifft die vorliegende Erfindung eine Fernbedienung für ein Hörgerät mit einer derartigen Sende-Empfangsschaltung.

Als nächstkommender Stand der Technik ist die Druckschrift DE 103 04 479 B3 bekannt. Dort ist eine Vorrichtung zum Senden und Empfangen von Daten für Fernbedienungen von Hörgeräten beschrieben. Es wird gezeigt, wie eine kombinierte Sende-Empfangseinheit mit einer einzigen Sende-Empfangsantenne realisiert werden kann, ohne den nachgeschalteten Empfänger zu überlasten. Dabei werden Standard-Silizium-Schutzdioden eingesetzt, die bei niedrigen Frequenzen und vergleichsweise hohen Resonanzkapazitäten gut funktionieren, wobei deren Sperrkapazität vernachlässigbar ist. Diese Dioden sind erforderlich, um im Sendefall die Spannung am Eingang der Empfangsschaltung zu begrenzen. Sie sind also für die kombinierte Sende-Empfangsschaltung unverzichtbar.

Es besteht der Bedarf, mit den Sende-Empfangsschaltungen von Hörgeräten auch höhere Bandbreiten bewältigen zu können. Sobald jedoch bei der oben beschriebenen, bekannten Vorrichtung zur Übertragung höherer Bandbreiten auf höhere Frequenzen gewechselt wird, kommen kleinere Induktivitäten und auch kleinere Kapazitäten zum Einsatz. Dadurch sind die Sperrkapazitäten der Schutzdioden nicht mehr vernachlässigbar und verstimmen den Resonanzkreis im Empfangsteil erheblich. Außerdem sind die Sperrkapazitäten der Dioden nicht bekannt und können mit dem Herstellungsprozess variieren. Dadurch wird eine saubere Abstimmung des Schwingkreises im Empfangsteil sehr schwierig und müsste individuell in jedem Gerät manuell mit hohem Aufwand durchgeführt werden. Ein Verzicht auf diese Dioden ist jedoch nicht möglich, da sie als Eingangsschutzelemente für den Empfangsverstärker unbedingt nötig sind. Ohne Schutz würden am Eingang des Empfangsverstärkers im Sendefall sehr hohe Spannungen auftreten, die zur Zerstörung des Empfangsverstärkers führen würden.

In der weiteren Druckschrift EP 1 301 017 A1 ist ein mobiles Kommunikationsgerät mit elektrostatischem Entladungsschutz beschrieben. Zwei PIN-Dioden sind antiparallel zwischen den Hochfrequenzeingang des Empfängers und Masse geschaltet. Sie dienen als Überspannungsschutz und zeichnen sich aufgrund ihrer sehr geringen Kapazität durch ihren minimalen Effekt auf Hochfrequenzsignale aus.

In der weiteren Druckschrift WO 87/01199 ist eine Sende-Empfangsschaltung einer Magnet-Resonanz-Bildgebungsvorrichtung beschrieben. Sie umfasst eine Sende-Empfangsantenne, einen Empfangsschwingkreis, der an die Sende-Empfangsantenne angeschlossen ist, und einen Verstärker, der an den Empfangsschwingkreis angeschlossen ist. Zwischen dem Empfangsschwingkreis und dem Verstärker sind zwei PIN-Dioden antiparallel und Kapazitätsdioden parallel geschaltet.

Die Aufgabe der vorliegenden Erfindung besteht somit darin, eine Sende-Empfangsschaltung mit einer einzigen Sende-Empfangsantenne vorzuschlagen, die auch zur Übertragung höherer Bandbreiten geeignet ist.

Erfindungsgemäß wird diese Aufgabe gelöst durch eine Sende-Empfangsschaltung mit einer Sende-Empfangsantenne, einem Empfangsschwingkreis, der an die Sende-Empfangsantenne angeschlossen ist, und einem Verstärker, der an den Empfangsschwingkreis angeschlossen ist, wobei zwischen den Empfangsschwingkreis und den Verstärker mindestens zwei PIN-Dioden antiparallel zum Schutz des Verstärkers geschaltet sind. An die Sende-Empfangsantenne ist ein Sender gekoppelt, der zur Abstimmung des Empfangsschwingkreises mit gegenüber seinem bestimmungsgemäßen Senden reduzierter Leistung bei der Resonanzfrequenz des Empfangsschwingkreises betreibbar ist. Durch derartige Anregung des Empfangsschwingkreises kann dieser durch Messung der Amplitude im Empfänger einfach abgestimmt werden.

Parallel zu den PIN-Dioden kann eine Kapazitätsdiode geschaltet werden. Dadurch kann eine ausreichende Abstimmung des Empfangsschwingkreises auch bei größeren Bauteiltoleranzen erreicht werden.

In vorteilhafter Weise besitzen die erfindungsgemäß eingesetzten PIN-Dioden geringere Sperrschichtkapazitäten, so dass die Sende-Empfangsschaltung auch für höhere Frequenzen eingesetzt werden kann. Falls in der Empfangsschaltung höhere Ströme zu erwarten sind, können dem einen antiparallelen PIN-Diodenpaar weitere antiparallel geschaltete PIN-Diodenpaare parallel geschaltet werden.

An die Kapazitätsdiode kann eine Steuerspannung zum Trimmen des Empfangsschwingkreises gelegt sein. Mit dieser Steuerung lässt sich der Empfangsschwingkreis gegebenenfalls auch automatisch abgleichen.

Es ist notwendig zwischen Kapazitätsdiode und Pin-Dioden einen Kondensator zu schaffen, um die DC-Steuerspannung an der Kapazitätsdiode gegen den Schwingkreis zu entkoppeln.

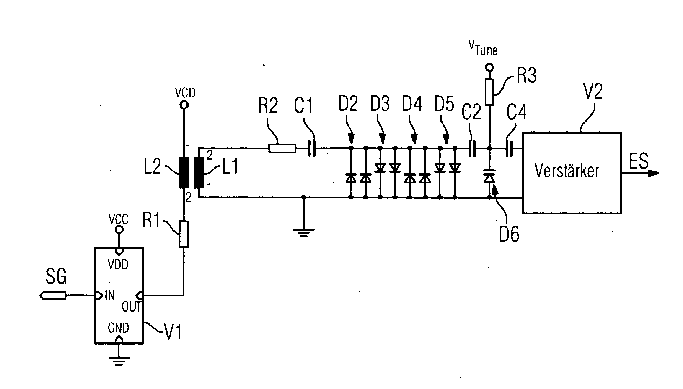

Die vorliegende Erfindung wird nun an Hand der beigefügten Zeichnung näher erläutert, die ein Schaltbild einer erfindungsgemäßen Sende-Empfangsschaltung zeigt.

Das nachfolgend näher geschilderte Ausführungsbeispiel stellt eine bevorzugte Ausführungsform der vorliegenden Erfindung dar.

Die in der FIG darstellte Sende-Empfangsschaltung für ein Hörgerät besitzt eine Sende-Empfangsantenne L1, die als Spule ausgebildet ist. An sie ist eine zweite Spule L2 lose gekoppelt, die zum induktiven Übertragen eines Sendesignals eines Sendeverstärkers V1 dient. Dazu ist der Sendeverstärker V1 über einen Widerstand R1 mit der Spule L2 gekoppelt. Die Spule L2 ist andererseits mit einer Versorgungsspannung VCC verbunden. Ebenso wird der Sendeverstärker V1 mit der Versorgungsspannung VCC an seinem Versorgungsspannungspin VDD versorgt. An dem Pin GND ist er an Masse gelegt. Über seinen Eingang IN erhält er ein zu verstärkendes Sendesignal SG. Der Sendeverstärker V1 ist nur beim Senden aktiv und im Empfangsfall ausgeschaltet.

Die Empfangsschaltung ist an die Sende-Empfangsantenne L1 angeschlossen. Die Antennenspule L1 bildet zusammen mit einem über einen Widerstand R2 verbundenen Haupteinstellkondensator C1 einen Resonanzkreis, der beim Empfang zu Schwingungen angeregt wird. Das Signal des Resonanzschwingkreises wird durch einen Verstärker V2, der ein geringes Eigenrauschen aufweist, verstärkt, so dass sich ein entsprechend verstärktes Empfangssignal ES ergibt.

Da sich der Empfangsteil (in der FIG rechts neben der Sende-Empfangsantenne L1) auch beim Senden aufschwingt, wobei dann sehr hohe Feldstärken und entsprechend hohe induzierte Spannungen auftreten, muss der Empfangsverstärker V2 in geeigneter Weise geschützt werden. Daher ist hier parallel zu dem Empfangsschwingkreis L1, C1 ein PIN-Diodenarray bestehend aus den PIN-Diodenpaaren D2, D3, D4 und D5 geschaltet. Die einzelnen Diodenpaare bestehen hier aus jeweils zwei parallel geschalteten PIN-Dioden. Die PIN-Diodenpaare D2 und D3 sind antiparallel geschaltet, ebenso wie die PIN-Diodenpaare D4 und D5. Prinzipiell könnte an Stelle des PIN-Diodenarrays ein einfaches antiparallel geschaltetes PIN-Diodenpaar eingesetzt werden, wenn die auftretenden Ströme entsprechend niedrig sind. Bei höheren Strömen ist die Anzahl der PIN-Dioden entsprechend anzupassen.

Im Empfangsfall, wenn das Signal sehr klein ist und nicht über der Schaltschwelle der PIN-Dioden liegt, sperrt das PIN-Diodenarray. Im Sendefall hingegen, wenn das Signal entsprechend hoch ist, bildet das PIN-Diodenarray einen Kurzschluss, wodurch der Verstärker V2 geschützt ist.

Über einen Kondensator C2 ist eine Varactor-Diode parallel zu dem PIN-Diodenarray, d. h. parallel zu dem Eingang des Verstärkers V2 geschaltet. Im Empfangsfall kompensiert der Kondensator C2 zusammen mit der Kapazität der Varactor-Diode D6 den Wegfall der Spule L2.

Damit die Kapazität der Varactor-Diode D6 entsprechend eingestellt werden kann, ist der Verbindungspunkt zwischen dem Kondensator C2 und der Varactor-Diode D6 über einen Widerstand R3 an eine Einstellspannung V_{Tune} gelegt. Über einen Koppelkondensator C4 ist der Verbindungspunkt zwischen dem Kondensator C2 und der Varactor-Diode D6 mit dem einen Eingangsanschluss des Verstärkers V2 verbunden. Der andere Eingangsanschluss, der mit der Anode der Varactor-Diode, einem gemeinsamen Kontakt des PIN-Diodenarrays und einem Anschluss der Sende-Empfangsantenne L1 verbunden ist, liegt an Masse.

Nachfolgend wird die Funktionsweise der erfindungsgemäßen Sende-Empfangsschaltung näher erläutert. Da hier anstatt von normalen Dioden PIN-Dioden eingesetzt sind, ist auch bei höheren Frequenzen die Verstimmung des Schwingkreises im Empfangsfall gering, denn diese PIN-Dioden besitzen sehr kleine Sperrkapazitäten. Obendrein kann zur Kompensation dieses relativ kleinen Restfehlers noch eine Kapazität- bzw. Varactor-Diode D6 eingesetzt werden, die eventuelle Restfehler kompensieren kann. Diese Varactor-Diode D6 lässt sich entweder manuell mit einer passenden Steuerspannung V_{Tune}belegen, oder der Trimmvorgang wird automatisch durch Messen der Schwingkreis-Amplitude bei Resonanzfrequenz durchgeführt und es findet ein interaktiver Abgleich statt. Damit wird der Abstimmvorgang auf die Einstellung eines einzigen Trimmpotentiometers reduziert oder kann sogar voll automatisch durchgeführt werden. Die Kapazitätsdiode sollte nur im Zusammenhang mit den PIN-Dioden eingesetzt werden, da die Sperrschichtkapazität von normalen Dioden in der Regel zu hoch ist und von einer Kapazitätsdiode nicht vollständig kompensiert werden könnte.

Die Automatisierung des Abgleichsverfahrens ist insbesondere deswegen vorteilhaft, weil die gesamte Schaltung einem Alterungsprozess und Temperaturschwankungen unterworfen ist. Daher bietet sich ein automatischer Abgleich bei jedem Umschalten vom Senden auf Empfangen oder umgekehrt an. Die Automatisierung lässt sich durch Aktivieren des Senders auf der Resonanzfrequenz mit minimaler Leistung (z. B. reduziert durch Vorwiderstand) und Messen der Empfangsspannung hinter dem Low-Noise-Empfangsverstärker V2 realisieren. Die Frequenzabstimmung ist optimal, wenn die maximale Spannung erreicht ist. Alternativ kann die Empfangsspannung einfach mit einer Referenzspannung verglichen werden und die Sendeleistung wird variiert. In dem Moment, in dem die Referenzspannung nicht mehr erreicht wird, ist die Sendeleistung zu gering. Daraufhin muss die Leistung wieder eine Stufe erhöht werden. Die Abstimmung kann verändert werden, wenn beim Durchstimmen die Referenzspannung erreicht/überschritten wird.

In vorteilhafter Weise kann die erfindungsgemäße Sende-Empfangsschaltung mit den PIN-Dioden auch bei höheren Frequenzen bis zu einigen MHz eingesetzt werden. Darüber hinaus können durch die Kapazitätsdiode D6 größere Bauteiltoleranzen zugelassen werden. Dies führt zu verringerten Bauteilkosten. Obendrein kann der Schwingkreis im Empfangsfall exakt abgestimmt werden. Damit lassen sich hohe Güten erreichen, was gute Empfangseigenschaften bei geringer Störempfindlichkeit bedeutet und damit zu großen Empfangsreichweiten führt. Häufig können die Sender mit weniger Energie betrieben werden, ohne Reichweite zu verlieren.

## Patentansprüche

1. Sende-Empfangsschaltung mit einer Sende-Empfangsantenne (L1), einem Empfangsschwingkreis, der an die Sende-Empfangsantenne (L1) angeschlossen ist, und einem Verstärker (V2), der an den Empfangsschwingkreis angeschlossen ist, **dadurch gekennzeichnet**, wobei zwischen dem Empfangsschwingkreis und dem Verstärker (V2) mindestens zwei PIN-Dioden (D2 bis D5) antiparallel zum Schutz des Verstärkers (V2) geschaltet sind,
**dadurch gekennzeichnet,**
**dass** an die Sende-Empfangsantenne (L1) ein Sender angeschlossen ist, der zur Abstimmung des Empfangsschwingkreises mit einer gegenüber seinem bestimmungsgemäßen Senden reduzierten Leistung bei der Resonanzfrequenz des Empfangsschwingkreises betreibbar ist.

2. Sende-Empfangsschaltung nach Anspruch 1, wobei parallel zu den PIN-Dioden (D2 bis D5) eine Kapazitätsdiode (D6) geschaltet ist.

3. Sende-Empfangsschaltung nach Anspruch 2, wobei an die Kapazitätsdiode (D6) eine Steuerspannung (V_{Tune}) zum Trimmen des Empfangsschwingkreises gelegt ist.

4. Fernbedienung für Hörgerät mit einer Sende-Empfangsschaltung nach einem der vorhergehenden Ansprüche.

## Claims

1. Transmit/receive circuit with a transmit/receive antenna (L1), a receive oscillating circuit, which is connected to the transmit/receive antenna (L1), and an amplifier (V2), which is connected to the receive oscillating circuit,
**characterised in that** with at least two PIN diodes (D2 to D5) connected in an anti-parallel manner between the receive oscillating circuit and the amplifier (V2) to protect the amplifier (V2),
**characterised in that**
a transmitter is connected to the transmit/receive antenna (L1) which can be operated with reduced power compared with its stipulated transmission at the resonant frequency of the receive oscillating circuit, to tune the receive oscillating circuit.

2. Transmit/receive circuit according to claim 1, with a capacitance diode (D6) connected parallel to the PIN diodes (D2 to D5).

3. Transmit/receive circuit according to claim 2, with a control voltage (V_{Tune}) being applied to the capacitance diode (D6) to trim the receive oscillating circuit.

4. Remote control for a hearing device with a transmit/receive circuit according to one of the preceding claims.

## Revendications

1. Circuit d'émission-réception comprenant une antenne ( L1 ) d'émission-réception, un circuit de réception, qui est raccordé à l'antenne (L1) d'émission-réception et un amplificateur ( V2 ), qui est raccordé à un circuit oscillant de réception, **caractérisé en ce qu'**entre le circuit oscillant de réception et l'amplificateur ( V2 ) au moins deux diodes ( D2 à D5 ) PIN sont montées tête-bêche pour la protection de l'amplificateur ( V2 ),
**caractérisé**
**en ce qu'**à l'antenne ( L1 ) d'émission-réception est raccordée un émetteur, qui peut fonctionner, à la fréquence de résonance du circuit oscillant de réception, pour accorder le circuit oscillant de réception à une puissance réduite par rapport à son émission conforme à la prescription.

2. Circuit d'émission-réception suivant la revendication 1, dans lequel une diode ( D6 ) de capacité est montée en parallèle aux diodes ( D2 à D5 ) PIN.

3. Circuit d'émission-réception suivant la revendication 2, dans lequel une tension ( V_{TUNE} ) de commande pour l'équilibrage du circuit oscillant de réception est appliquée à la diode ( D6 ) de capacité.

4. Télécommande de prothèse auditive comprenant un circuit d'émission-réception suivant l'une des revendications précédentes.
